# EUROPEAN PATENT SPECIFICATION

(11) **EP 4 618 728 B1**
(45) Date of publication and mention of the grant of the patent: **26.08.2026**
(21) Application number: 25159259.8
(22) Date of filing: 21.02.2025
(51) Int. Cl.: H10F 39/00

(54) **IMAGE SENSING DEVICE**
BILDAUFNAHMEVORRICHTUNG
DISPOSITIF DE PRISE D'IMAGE

(30) Priority: 14.03.2024 KR 20240035835
(43) Date of publication of application: 17.09.2025
(73) Proprietor: SK hynix Inc., Bubal-eub Icheon-si Gyeonggi-do 17336 (KR)
(72) Inventor: CHO, Hyun Soo, 17336 Icheon-si, Gyeonggi-do (KR)
(74) Representative: Isarpatent

(56) References cited:
- WO-A1-2023/026913
- US-A1- 2021 399 037
- US-A1- 2023 005 977

## Description

### TECHNICAL FIELD

The technology and implementations disclosed in this patent document generally relate to an image sensing device.

### BACKGROUND

An image sensor is used in electronic devices to convert optical images into electrical signals. With the recent development of automotive, medical, computer and communication industries, the demand for highly integrated, higher-performance image sensors has been rapidly increasing in various electronic devices such as digital cameras, camcorders, personal communication systems (PCSs), video game consoles, surveillance cameras, medical micro-cameras, robots, etc.

WO 2023/026913 and US 2021/0399037 disclose an image device including an air grid structure. An air layer of the air grid structure enclosed by a capping film.

### SUMMARY

Various embodiments of the disclosed technology relate to an image sensing device capable of improving the stability of a grid structure including an air layer. The present invention is set out by the appended claims.

In accordance with the present invention, an image sensing device, as defined by independent claim 1, includes a plurality of color filters; and a grid structure disposed between the color filters and configured to prevent optical crosstalk between adjacent color filters, wherein the grid structure includes: a first capping layer structured to define and to cover a space filled with air to form an air layer, and including a plurality of holes; and a second capping layer disposed at an outer surface and an inner surface of the first capping layer and configured to fill the plurality of holes. The second capping layer includes an inner capping layer disposed at the inner surface of the first capping layer, and an outer capping layer disposed at the outer surface of the first capping layer and connected to the inner capping layer through the plurality of holes. The first capping layer and the outer capping layer extend to a lower portion of the color filters.

It is to be understood that both the foregoing general description and the following detailed description of the disclosed technology are illustrative and explanatory and are intended to provide further explanation of the disclosure as claimed.

### BRIEF DESCRIPTION OF THE DRAWINGS

The above and other features and beneficial aspects of the disclosed technology will become readily apparent with reference to the following detailed description when considered in conjunction with the accompanying drawings.
FIG. 1 is a block diagram illustrating an example of an image sensing device based on some implementations of the disclosed technology.
FIG. 2 is a plan view illustrating an example of a grid structure formed in a pixel region shown in FIG. 1 based on some implementations of the disclosed technology.
FIG. 3A is a cross-sectional view illustrating an example of a cross-sectional structure taken along the line A-A' shown in FIG. 2, and FIG. 3B is a cross-sectional view illustrating an example of a cross-sectional structure taken along the line B-B' shown in FIG. 2.
FIGS. 4A to 4G are cross-sectional views illustrating examples of methods for forming a grid structure of FIG. 3A based on some implementations of the disclosed technology.

### DETAILED DESCRIPTION

This patent document provides implementations and examples of an image sensing device that may be used to substantially address one or more technical or engineering issues and mitigate limitations or disadvantages encountered in some other image sensing devices. Some implementations of the disclosed technology suggest examples of an image sensing device that can improve the stability of a grid structure including an air layer. In recognition of the issues above, the disclosed technology provides various implementations of the image sensing device that can improve the stability of a grid structure including an air layer.

Reference will now be made in detail to certain embodiments, examples of which are illustrated in the accompanying drawings. Wherever possible, the same reference numbers will be used throughout the drawings to refer to the same or similar parts. In the following description, a detailed description of related known configurations or functions incorporated herein will be omitted to avoid obscuring the subject matter.

Hereinafter, various embodiments will be described with reference to the accompanying drawings. The embodiments of the disclosed technology may provide a variety of effects capable of being directly or indirectly recognized through the disclosed technology.

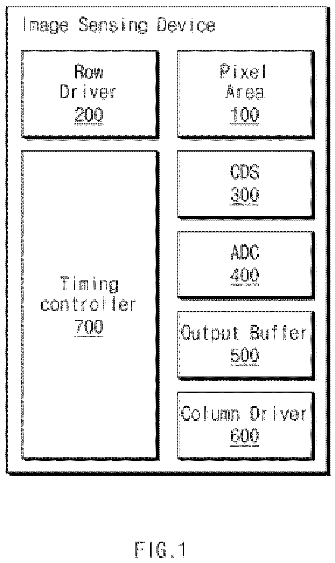

FIG. 1 is a block diagram illustrating an example of an image sensing device based on some implementations of the disclosed technology.

Referring to FIG. 1, the image sensing device may include a pixel region 100, a row driver 200, a correlated double sampler (CDS) 300, an analog-to-digital converter (ADC) 400, an output buffer 500, a column driver 600, and a timing controller 700. The components of the image sensing device illustrated in FIG. 1 are discussed by way of example only, and this patent document encompasses numerous other changes, substitutions, variations, alterations, and modifications. In this patent document, the word "pixel" can be used to indicate an image sensing pixel that is structured to detect incident light to generate electrical signals carrying images in the incident light.

The pixel region 100 may include a plurality of unit pixels consecutively arranged in a two-dimensional (2D) structure. The unit pixels may convert incident light into electrical signals corresponding to the incident light, may generate pixel signals, and may output the pixel signals to the CDS 300 through column lines. The pixel region 100 may include a grid structure to prevent crosstalk between color filters of adjacent unit pixels. The grid structure may include a structure in which an air layer is capped or covered by a capping layer. In some implementations, the grid structure may include a structure to prevent collapse of the capping layer due to expansion of the air layer during a heat treatment process. This collapse prevention structure will be described in more detail later.

The pixel region 100 may receive driving signals (for example, a row selection signal, a reset signal, a transfer signal, etc.) from the row driver 200. Upon receiving the driving signals, the unit pixels may be activated to perform the operations corresponding to the row selection signal, the reset signal, and the transfer signal.

The row driver 200 may activate the pixel region 100 to perform certain operations on the unit pixels in the corresponding row based on control signals provided by controller circuitry such as the timing controller 700. In some implementations, the row driver 200 may select one or more pixel groups arranged in one or more rows of the pixel region 100. The row driver 200 may generate a row selection signal to select one or more rows from among the plurality of rows. The row driver 200 may sequentially enable the reset signal and the transfer signal for the unit pixels arranged in the selected row. The pixel signals generated by the unit pixels arranged in the selected row may be output to the correlated double sampler (CDS) 300.

The correlated double sampler (CDS) 300 may remove undesired offset values of the unit pixels using correlated double sampling. In one example, the correlated double sampler (CDS) 300 may remove the undesired offset values of the unit pixels by comparing output voltages of pixel signals (of the unit pixels) obtained before and after photocharges generated by incident light are accumulated in the sensing node (i.e., a floating diffusion (FD) node). As a result, the CDS 300 may obtain a pixel signal generated only by the incident light without causing noise. In some implementations, upon receiving a clock signal from the timing controller 700, the CDS 300 may sequentially sample and hold voltage levels of the reference signal and the pixel signal, which are provided to each of a plurality of column lines from the pixel region 100. That is, the CDS 300 may sample and hold the voltage levels of the reference signal and the pixel signal which correspond to each of the columns of the pixel region 100. In some implementations, the CDS 300 may transfer the reference signal and the pixel signal of each of the columns as a correlate double sampling (CDS) signal to the ADC 400 based on control signals from the timing controller 700.

The ADC 400 is used to convert analog CDS signals received from the CDS 300 into digital signals. In some implementations, the ADC 400 may be implemented as a ramp-compare type ADC. The analog-to-digital converter (ADC) 400 may compare a ramp signal received from the timing controller 700 with the CDS signal received from the CDS 300, and may thus output a comparison signal indicating the result of comparison between the ramp signal and the CDS signal. The analog-to-digital converter (ADC) 400 may count a level transition time of the comparison signal in response to the ramp signal received from the timing controller 700, and may output a count value indicating the counted level transition time to the output buffer 500.

The output buffer 500 may temporarily store column-based image data provided from the ADC 400 based on control signals of the timing controller 700. The image data received from the ADC 400 may be temporarily stored in the output buffer 500 based on control signals of the timing controller 700. The output buffer 500 may provide an interface to compensate for data rate differences or transmission rate differences between the image sensing device and other devices.

The column driver 600 may select a column of the output buffer 500 upon receiving a control signal from the timing controller 700, and sequentially output the image data, which are temporarily stored in the selected column of the output buffer 500. In some implementations, upon receiving an address signal from the timing controller 700, the column driver 600 may generate a column selection signal based on the address signal, may select a column of the output buffer 500 using the column selection signal, and may control the image data received from the selected column of the output buffer 500 to be output as an output signal.

The timing controller 700 may generate signals for controlling operations of the row driver 200, the ADC 400, the output buffer 500 and the column driver 600. The timing controller 700 may provide the row driver 200, the column driver 600, the ADC 400, and the output buffer 500 with a clock signal required for the operations of the respective components of the image sensing device, a control signal for timing control, and address signals for selecting a row or column. In some implementations, the timing controller 700 may include a logic control circuit, a phase lock loop (PLL) circuit, a timing control circuit, a communication interface circuit and others.

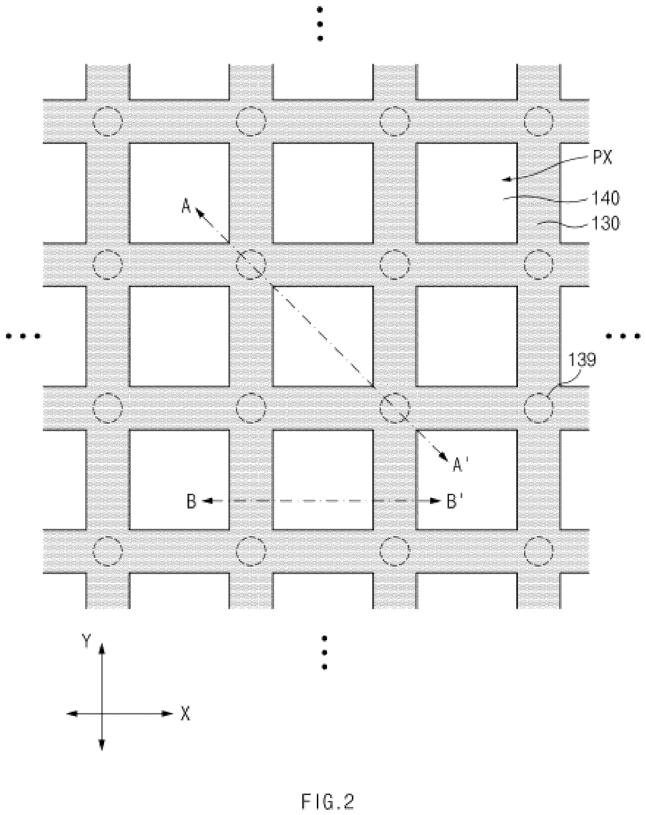

FIG. 2 is a plan view illustrating an example of a grid structure formed in a pixel region shown in FIG. 1 based on some implementations of the disclosed technology.

Referring to FIG. 2, the pixel region 100 may include a plurality of unit pixels (PXs) consecutively arranged in a first direction (e.g., X-axis direction) and a second direction (e.g., Y-axis direction) perpendicular to the first direction.

The pixel region 100 may include a grid structure 130 disposed between color filters 140 of adjacent unit pixels (PXs) to prevent optical crosstalk between adjacent color filters 140. The grid structure 130 may include a plurality of first portions extending in a first direction and a plurality of second portions extending in a second direction. In the example as shown in FIG. 2, the first portions and the second portions of the grid structure 130 may extend across the pixel region 100 and be disposed between color filters 140. The first portions and the second portions of the grid structure 130 may be formed to cross each other and surround each of the color filters 140.

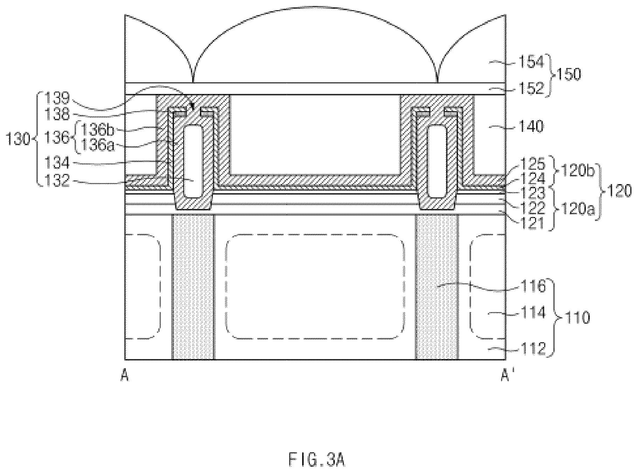

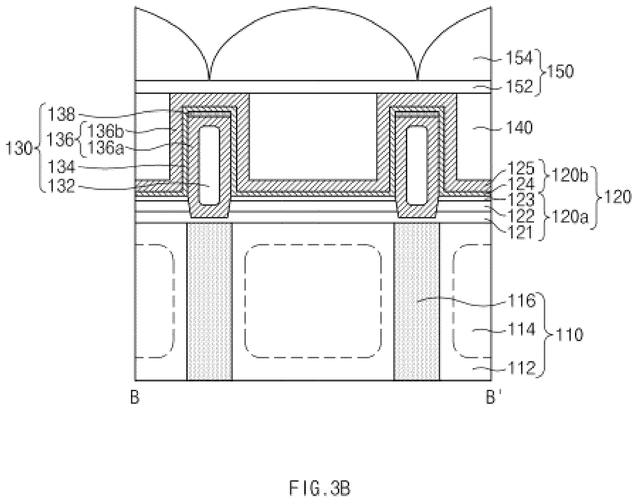

The grid structure 130 may include an air layer and a capping layer that caps or covers the air layer. The capping layer is structured to define a space filled with air to form the air layer. The capping layer may include a multilayer structure in which a plurality of insulation layers is formed to overlap each other. As later shown in an example in FIGS. 3A and 3B, the grid structure 130 may be structured to include such an air layer 132, a first capping layer 134 with holes 139, a second capping layer 136, and a support layer 138. The capping layer may include an ultra-low temperature oxide (ULTO) layer such as a silicon oxide (SiO₂) layer.

While the capping layer includes multiple insulation layers, the insulation layer of the capping layer may include a plurality of collapse prevention holes 139 through which a portion of the upper surface passes. The collapse prevention holes 139 may be formed to prevent the capping layer from collapsing due to expansion of the air layer during the process of forming the grid structure 130.

Although FIG. 2 shows an example case in which the collapse prevention holes 139 are formed only in some regions in which the first portions and the second portions are arranged to cross each other in the grid structure 130, other implementations are also possible, other implementations are also possible. It should be noted that the position and number of the collapse prevention holes 139 may be changed in various implementations.

FIG. 3A is a cross-sectional view illustrating an example of a cross-sectional structure taken along the line A-A' shown in FIG. 2, and FIG. 3B is a cross-sectional view illustrating an example of a cross-sectional structure taken along the line B-B' shown in FIG. 2.

Referring to FIGS. 3A and 3B, the pixel region 100 of the image sensing device may include a substrate layer 110, a buffer layer 120, a grid structure 130, color filters 140, and a lens layer 150.

The substrate layer 110 may include a substrate 112, photoelectric conversion elements 114, and a pixel isolation structure 116.

The substrate 112 may include a semiconductor substrate having a first surface and a second surface facing or opposite to the first surface. In the example, the first surface is a surface upon which light is incident, and the buffer layer 120, the grid structure 130, the color filters 140, and the lens layer 150 may be formed thereon. The semiconductor substrate 112 may be in a monocrystalline state, and may include a silicon-containing material. In some implementations, the semiconductor substrate 110 may include a monocrystalline silicon-containing material. The semiconductor substrate 112 may include P-type impurities. The semiconductor substrate layer 112 may include photoelectric conversion elements 114.

The photoelectric conversion elements 114 may perform conversion of incident light received through the first surface of the semiconductor substrate 112, resulting in formation of photocharges. The photoelectric conversion elements 114 may be formed in the semiconductor substrate 112 to respectively correspond to the unit pixels (PXs). In some implementations, each of the photoelectric conversion elements 114 may be formed for each unit pixel (PX) in the semiconductor substrate 112. The photoelectric conversion elements 114 may be isolated from each other by the pixel isolation structure 116. Each photoelectric conversion element 114 may include impurity regions stacked vertically within the semiconductor substrate 112. For example, each photoelectric conversion element 114 may include a photodiode in which an N-type impurity region and a P-type impurity region are stacked in a vertical direction.

The pixel isolation structure 116 may be formed between adjacent photoelectric conversion elements 114 within the semiconductor substrate 112 so that the photoelectric conversion elements 114 can be isolated from each other for each pixel. In some implementations, the pixel isolation structure 116 may include a trench structure such as Back Deep Trench Isolation (BDTI) or Front Deep Trench Isolation (FDTI). In some other implementations, the pixel isolation structure 116 may include a junction isolation structure in which a high concentration of impurities (e.g., P-type impurities) is implanted into the semiconductor substrate 112.

The buffer layer 120 may be disposed between the semiconductor substrate 112 and the color filters 140 over the first surface of the substrate layer 110. The buffer layer 120 may operate as a planarization layer to remove a step difference formed over the first surface of the substrate layer 110. In addition, the buffer layer 120 may operate as an anti-reflection layer to allow incident light to pass through the photoelectric conversion elements 114.

The buffer layer 120 may include a multilayer structure formed by stacking an oxide layer and a nitride layer. For example, the buffer layer 120 may include a lower buffer layer 120a and an upper buffer layer 120b.

The lower buffer layer 120a may be formed under the grid structure 130 and the color filters 140 on the substrate layer 110. In some implementations, the lower buffer layer 120a may be formed entirely under the grid structure 130 and the color filters 140 on the substrate layer 110. The lower buffer layer 120a may include first to third buffer layers (121, 122, 123). The first buffer layer 121 may include a metal oxide layer such as aluminum oxide (Al₂O₃) or hafnium oxide (HfO₂). The second buffer layer 122 may include a silicon oxide (SiO₂) layer, and the third buffer layer 123 may include a nitride layer such as a silicon nitride layer or a silicon oxynitride layer.

The upper buffer layer 120b may be formed between the lower buffer layer 120a and the color filters 140. The upper buffer layer 120b may include a fourth buffer layer 124 and a fifth buffer layer 125. The fourth buffer layer 124 and the fifth buffer layer 125 may be formed of the same material as the first capping layer 134 and the second capping layer 136 of the grid structure 130, respectively, and may be formed together through the same deposition process. For example, the fourth buffer layer 124 and the fifth buffer layer 125 may be formed such that the first capping layer 134 and the second capping layer 136 extend below the color filter 140. The fourth buffer layer 124 and the fifth buffer layer 125 may include an ultra-low temperature oxide (ULTO) layer.

The grid structure 130 may be located between the color filters 140 to prevent optical crosstalk between adjacent color filters. The grid structure 130 may be disposed to overlap the pixel isolation structure 116 in the vertical direction. Each of the grid structures 130 may be structured to include a space filled with air as an air layer 132, a first capping layer 134, a second capping layer 136, and a support layer 138.

In certain implementations, the first capping layer 134 and the second capping layer 136 may cap or cover the air layer 132. Referring to the example in FIGS. 3A and 3B, the second capping layer 136 may include an inner capping layer 136a formed over the inner surface of the first capping layer 134, and an outer capping layer 136b formed over the outer surface of the first capping layer 134. In some implementations, the inner capping layer 136a may surround the air layer 134. The first capping layer 134 may include a collapse prevention hole 139 that connects the inner capping layer 136a and the outer capping layer 136b to each other. The collapse prevention hole 139 is formed on the upper surface of the first capping layer 134 to provide a passage connecting the inner capping layer 136a and the outer capping layer 136b. The inner capping layer 136a and the outer capping layer 136b may be formed over the inner and outer surfaces of the first capping layer 134, respectively, and may seal the air layer 132 from the outside by filling the collapse prevention hole 139. Each of the inner capping layer 136a and the outer capping layer 136b may be formed thicker than the first capping layer 134. In some implementations, the inner capping layer 136a and the outer capping layer 136b may be formed to have the same thickness. Each of the first capping layer 134 and the second capping layer 136 may include an ultra-low temperature oxide (ULTO) layer.

The inner capping layer 136a and the air layer 132 may extend to the inside of the lower buffer layer 120a. For example, the bottom surface of the air layer 132 may extend to a position lower than the upper buffer layer 120b.

The support layer 138 serving as a layer for maintaining the shape of the first capping layer 134 may support the first capping layer 134 while the air layer 132 is formed to prevent the first capping layer 134 from collapsing. The support layer 138 may be disposed between the upper region of the first capping layer 134 and the inner capping layer 136a. The support layer 138 may include an insulation layer that does not have light absorption characteristics. For example, the support layer 138 may be or include an insulation layer with a different etch selectivity from an etch selectivity of a spin on carbon (SOC) layer containing carbon, and may include a silicon oxynitride (SiON) layer.

The color filters 140 may filter light incident through the lens layer 150 depending on colors of the incident light, and may allow the filtered light to pass therethrough. The color filters 140 may be disposed in a region defined by the grid structure 130 on the substrate layer 110. The color filters 140 may be located to correspond to the photoelectric conversion elements 114. The color filters 140 may include a plurality of red color filters, a plurality of green color filters, and/or a plurality of blue color filters. The color filters 140 may be arranged in a Bayer pattern.

The lens layer 150 may be disposed over the grid structure 130 and the color filters 140, and may condense incident light onto the photoelectric conversion elements 114. The lens layer 150 may include an overcoating layer 152 and microlenses 154. The overcoating layer 152 may operate as a planarization layer to compensate for (or remove) a step difference formed by the grid structure 130 and the color filters 140. The overcoating layer 152 may be formed of the same material as the microlens 154. For example, the overcoating layer 152 may include a photoresist material.

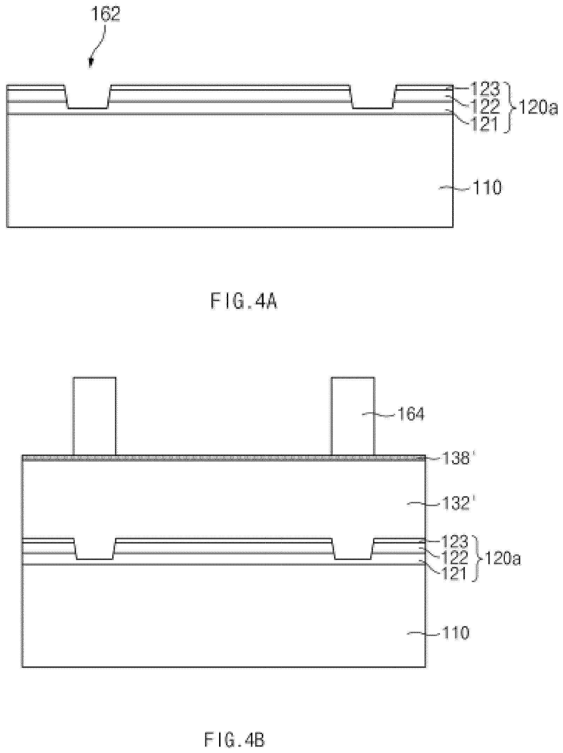

FIGS. 4A to 4G are cross-sectional views illustrating examples of methods for forming a grid structure of FIG. 3A based on some implementations of the disclosed technology.

First, referring to FIG. 4A, a lower buffer layer 120a may be formed over the substrate layer 110 in which the photoelectric conversion element and the pixel isolation structure are formed within the semiconductor substrate. For example, first to third buffer layers (121, 122, 123) may be sequentially formed over the substrate layer 110. At this time, the first buffer layer 121 may include a metal oxide layer such as aluminum oxide (Al₂O₃) or hafnium oxide (HfO₂). The second buffer layer 122 may include a silicon oxide (SiO₂) layer, and the third buffer layer 123 may include a nitride layer such as a silicon nitride layer a silicon oxynitride layer.

Subsequently, a trench 162 formed when a region in which the grid structure 130 is to be formed in the lower buffer layer 120a is etched to a predetermined depth may be formed. The trench 162 may be formed to expose the first buffer layer 121.

Referring to FIG. 4B, a sacrificial layer 132' may be formed over the lower buffer layer 120a in which the trench 162 is formed, and a support material layer 138' may be formed over the sacrificial layer 132'. In some implementations, the sacrificial layer 132' may include a spin on carbon (SOC) layer containing carbon, and the support material layer 138' may include a silicon oxynitride (SiON) layer.

Subsequently, a mask pattern 164 defining a region to be capped by the first capping layer 134 may be formed over the support material layer 138'. For example, a mask pattern 164 defining a region where the inner capping layer 136a and the air layer 132 of the grid structure 130 are to be formed may be formed over the support material layer 138'. The mask pattern 164 may include a photoresist pattern.

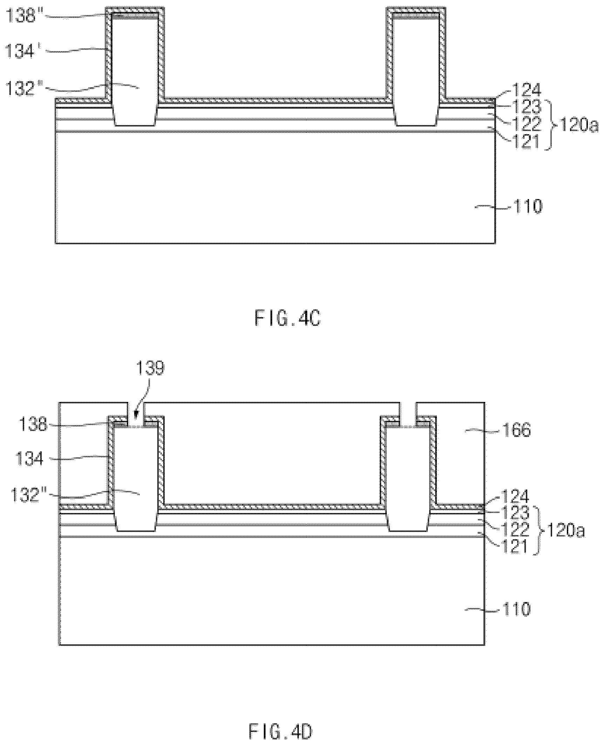

Referring to FIG. 4C, the support material layer 138' and the sacrificial layer 132' may be sequentially etched using the mask pattern 164 as an etch mask, so that the support layer pattern 138" and the sacrificial layer pattern 132" can be formed.

Subsequently, insulation layers (124, 134') may be formed to cover the lower buffer layer 120a, the sacrificial layer pattern 132", and the support layer pattern 138". Each of the insulation layers (124, 134') may include an ultra-low temperature oxide (ULTO) layer.

Referring to FIG. 4D, a mask pattern 166 may be formed over the insulation layers (124, 134') that define a region where the collapse prevention hole 139 will be formed. For example, the mask pattern 166 may be formed to expose the insulation layer 134' in regions where the first portions of the grid structure 130 cross the second portions of the grid structure 130. The mask pattern 166 may include a photoresist pattern.

Subsequently, the insulation layer 134' and the support layer pattern 138" are etched to expose the sacrificial layer pattern 132" using the mask pattern 166 as an etch mask, so that not only the first capping layer 134 including the collapse prevention hole 139, but also the support layer 138 can be formed.

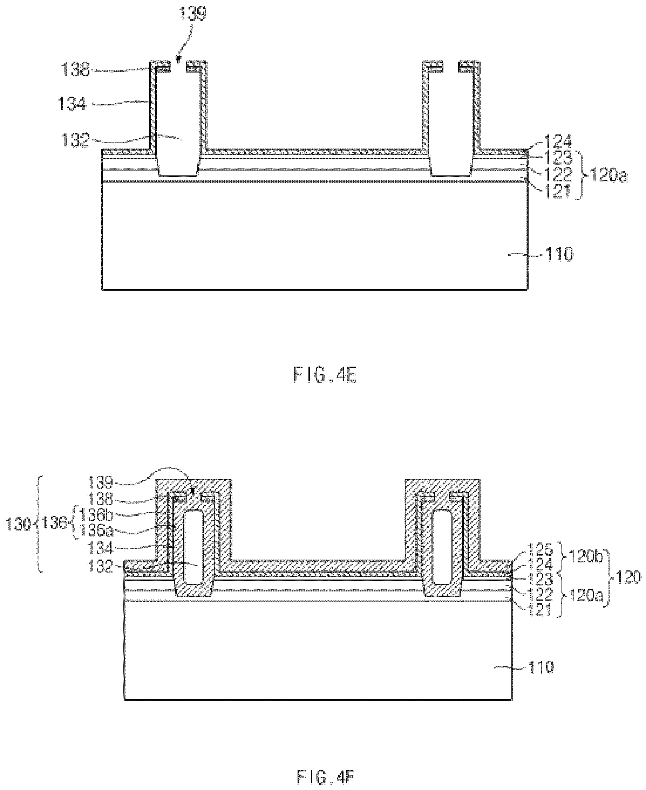

Referring to FIG. 4E, after the mask pattern 166 is removed, the sacrificial layer pattern 132" is removed through a plasma process, so that the air layer 132 may be formed at the position where the sacrificial layer pattern 132" was removed. The plasma process may be carried out using gas (e.g., O₂, N₂, H₂, CO, CO₂, or CH₄) including at least one of oxygen, nitrogen, or hydrogen.

For example, if the O₂ plasma process is carried out, oxygen radicals (O*) may flow into the sacrificial layer pattern 132" through the collapse prevention hole 139, and the oxygen radicals (O*) included in the sacrificial layer pattern 132" may be combined with carbons of the sacrificial layer pattern 132", resulting in formation of CO or CO₂. The formed CO or CO₂ may be discharged outside through the collapse prevention hole 139. As a result, the sacrificial layer pattern 132" can be removed, and the air layer 132 may be formed at the position where the sacrificial layer pattern 132" was removed.

When the first capping layer 134 is formed as a thin film, during the O₂ plasma process, oxygen radicals (O*) flow into the sacrificial layer pattern 132" not only through the collapse prevention hole 139 but also through the first capping layer 134, so that the oxygen radicals (O*) can be combined with carbons of the sacrificial layer pattern 132". In addition, the formed CO or CO₂ may be discharged outside not only through the collapse prevention hole 139, but also through the first capping layer 134.

If the O₂ plasma process is performed in a state in which the collapse prevention hole 139 is not formed in the first capping layer 134, the first capping layer 134 may collapse in a process for discharging the generated CO or CO₂ through the first capping layer 134. However, as in the present embodiment, when the O₂ plasma process is performed in a state in which the collapse prevention hole 139 is formed in the first capping layer 134, the generated CO or CO₂ is discharged through the collapse prevention hole 139, thereby preventing collapse of the first capping layer 134. The support layer 138 formed over the sacrificial layer pattern 132" may support the first capping layer 134 while the sacrificial layer pattern 132" is removed, so that the support layer 138 can prevent collapse of the first capping layer 134.

Referring to FIG. 4F, the second capping layer 136 and the fifth buffer layer 125 may be formed by depositing an oxide layer on the inner and outer surfaces of the first capping layer 134 where the collapse prevention hole 139 is formed. For example, the Ultra Low Temperature Oxide (ULTO) layer may be deposited on the inner and outer surfaces of the first capping layer 134 using an atomic layer deposition (ALD) process and/or a chemical vapor deposition (CVD) process. In some implementations, the second capping layer 136 may be made of the same material as the first capping layer 134 or a different material from the first capping layer 134.

When the air layer is formed using the plasma process, the thickness of the first capping layer 134 may be formed as thin as possible. As a result, it is necessary to increase the thickness of the capping layer through an additional deposition process after forming the air layer.

As in the present embodiment, when the oxide layer deposition process is performed on the first capping layer 134 including the collapse prevention hole 139 using the atomic layer deposition (ALD) process and/or the chemical vapor deposition (CVD) process, the inner capping layer 136a and the outer capping layer 136b are respectively formed at the inner surface and the outer surface of the first capping layer 134, and the collapse prevention hole 139 is also blocked by the oxide layer, resulting in formation of the capping layer 136 formed to cap the air layer 132.

Each of the inner capping layer 136a and the outer capping layer 136b of the second capping layer 136 may be formed thicker than the first capping layer 134, and the inner capping layer 136a and the outer capping layer 136b may be formed to have the same thickness.

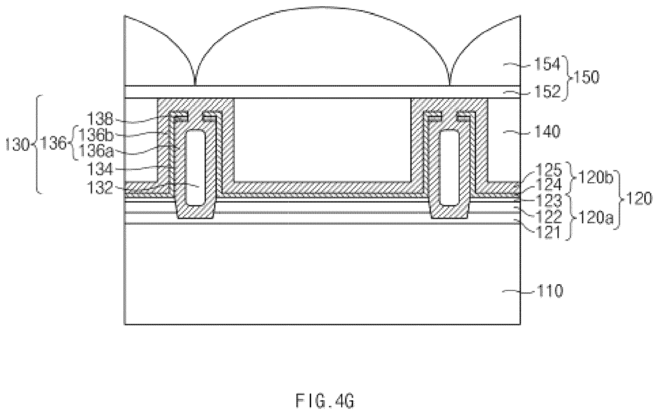

Referring to FIG. 4G, the color filters 140 may be formed between the grid structures 130.

Subsequently, the overcoating layer 152 and the microlenses 154 may be sequentially formed over the grid structure 130 and the color filters 140.

As is apparent from the above description, the image sensing device based on some implementations of the disclosed technology can improve the stability of a grid structure including an air layer.

The embodiments of the disclosed technology may provide a variety of effects capable of being directly or indirectly recognized through the above-mentioned patent document.

## Claims

1. An image sensing device comprising:
a plurality of color filters (140); and
a grid structure (130) disposed between the color filters (140) and configured to prevent optical crosstalk between adjacent color filters (140),
wherein the grid structure (130) includes:
a first capping layer (134) structured to define, and to cover, a space filled with air to form an air layer (132), the first capping layer (134) including a plurality of holes (139); and
a second capping layer (136) disposed at an outer surface and an inner surface of the first capping layer (134) and configured to fill the plurality of holes (139),
wherein the second capping layer (136) includes:
an inner capping layer (136a) disposed at the inner surface of the first capping layer (134); and
an outer capping layer (136b) disposed at the outer surface of the first capping layer (134) and connected to the inner capping layer (136a) through the plurality of holes (139), and
wherein the first capping layer (134) and the outer capping layer (136b) extend to a lower portion of the color filters (140).

2. The image sensing device according to claim 1, wherein:
each of the inner capping layer (136a) and the outer capping layer (136b) has a thickness greater than a thickness of the first capping layer (134).

3. The image sensing device according to claim 1, wherein:
the inner capping layer (136a) and the outer capping layer (136b) have a same thickness.

4. The image sensing device according to claim 1, wherein:
the air layer (132) extends to a position lower than a bottom surface of the first capping layer (134).

5. The image sensing device according to claim 1, further comprising:
a support layer (138) disposed between the first capping layer (134) and the inner capping layer (136a).

6. The image sensing device according to claim 1, wherein the grid structure (130) includes:
first portions extending in a first direction; and
second portions extending in a second direction cross to the first direction and crossing the first portions,
wherein the plurality of holes (139) is located in regions where the first portions and the second portions cross each other.

7. The image sensing device according to claim 1, wherein:
each of the first capping layer (134) and the second capping layer (136) includes an ultra-low temperature oxide, ULTO, layer.

8. The image sensing device according to claim 1, further comprising:
a lower buffer layer (120a) disposed between a semiconductor substrate (112) and the grid structure (130) and disposed between the semiconductor substrate (112) and the color filters (140); and
an upper buffer layer (120b) disposed between the lower buffer layer (120a) and the color filters (140).

9. The image sensing device according to claim 8, wherein:
the first capping layer (134) and the outer capping layer (136b) extend to operate as the upper buffer layer (120b).

10. The image sensing device according to claim 9, wherein:
the air layer (132) extends to an inside of the lower buffer layer (120a).

## Patentansprüche

1. Bilderfassungsvorrichtung, umfassend:
mehrere Farbfilter (140); und
eine Gitterstruktur (130), die zwischen den Farbfiltern (140) angeordnet und dazu ausgelegt ist, optisches Übersprechen zwischen benachbarten Farbfiltern (140) zu verhindern,
wobei die Gitterstruktur (130) aufweist:
eine erste Abdeckschicht (134), die strukturiert ist, um einen mit Luft gefüllten Raum zu definieren und abzudecken, um eine Luftschicht (132) zu bilden, wobei die erste Abdeckschicht (134) mehrere Löcher (139) aufweist; und
eine zweite Abdeckschicht (136), die an einer Außenfläche und einer Innenfläche der ersten Abdeckschicht (134) angeordnet und dazu ausgelegt ist, die mehreren Löcher (139) auszufüllen,
wobei die zweite Abdeckschicht (136) aufweist:
eine innere Abdeckschicht (136a), die an der Innenfläche der ersten Abdeckschicht (134) angeordnet ist; und
eine äußere Abdeckschicht (136b), die an der Außenfläche der ersten Abdeckschicht (134) angeordnet ist und durch die mehreren Löcher (139) mit der inneren Abdeckschicht (136a) verbunden ist, und
wobei sich die erste Abdeckschicht (134) und die äußere Abdeckschicht (136b) bis zu einem unteren Abschnitt der Farbfilter (140) erstrecken.

2. Bilderfassungsvorrichtung nach Anspruch 1, wobei:
sowohl die innere Abdeckschicht (136a) als auch die äußere Abdeckschicht (136b) eine Dicke aufweisen, die größer ist als eine Dicke der ersten Abdeckschicht (134).

3. Bilderfassungsvorrichtung nach Anspruch 1, wobei:
die innere Abdeckschicht (136a) und die äußere Abdeckschicht (136b) eine gleiche Dicke aufweisen.

4. Bilderfassungsvorrichtung nach Anspruch 1, wobei:
sich die Luftschicht (132) bis zu einer Position erstreckt, die niedriger gelegen ist als eine untere Fläche der ersten Abdeckschicht (134).

5. Bilderfassungsvorrichtung nach Anspruch 1, ferner umfassend:
eine Trägerschicht (138), die zwischen der ersten Abdeckschicht (134) und der inneren Abdeckschicht (136a) angeordnet ist.

6. Bilderfassungsvorrichtung nach Anspruch 1, wobei die Gitterstruktur (130) aufweist:
erste Abschnitte, die sich in einer ersten Richtung erstrecken; und
zweite Abschnitte, die sich in einer zweiten Richtung erstrecken, die quer zu der ersten Richtung verläuft und die ersten Abschnitte kreuzt,
wobei sich die mehreren Löcher (139) in Bereichen befinden, in denen sich die ersten Abschnitte und die zweiten Abschnitte kreuzen.

7. Bilderfassungsvorrichtung nach Anspruch 1, wobei:
sowohl die erste Abdeckschicht (134) als auch die zweite Abdeckschicht (136) eine Ultra-Niedertemperatur-Oxid-Schicht (ULTO-Schicht) aufweisen.

8. Bilderfassungsvorrichtung nach Anspruch 1, ferner umfassend:
eine untere Pufferschicht (120a), die zwischen einem Halbleitersubstrat (112) und der Gitterstruktur (130) angeordnet ist und zwischen dem Halbleitersubstrat (112) und den Farbfiltern (140) angeordnet ist; und
eine obere Pufferschicht (120b), die zwischen der unteren Pufferschicht (120a) und den Farbfiltern (140) angeordnet ist.

9. Bilderfassungsvorrichtung nach Anspruch 8, wobei:
sich die erste Abdeckschicht (134) und die äußere Abdeckschicht (136b) erstrecken, um als obere Pufferschicht (120b) zu fungieren.

10. Bilderfassungsvorrichtung nach Anspruch 9, wobei:
sich die Luftschicht (132) bis in ein Inneres der unteren Pufferschicht (120a) erstreckt.

## Revendications

1. Dispositif de prise d'image comprenant :
une pluralité de filtres colorés (140) ; et
une structure de grille (130) disposée entre les filtres colorés (140) et conçue pour empêcher une diaphonie optique entre des filtres colorés (140) adjacents,
dans lequel la structure de grille (130) comporte :
une première couche de recouvrement (134) structurée pour définir, et pour recouvrir, un espace rempli d'air afin de former une couche d'air (132), la première couche de recouvrement (134) comportant une pluralité de trous (139) ; et
une seconde couche de recouvrement (136) disposée sur une surface extérieure et une surface intérieure de la première couche de recouvrement (134) et conçue pour remplir la pluralité de trous (139),
dans lequel la seconde couche de recouvrement (136) comporte :
une couche de recouvrement intérieure (136a) disposée sur la surface intérieure de la première couche de recouvrement (134) ; et
une couche de recouvrement extérieure (136b) disposée sur la surface extérieure de la première couche de recouvrement (134) et reliée à la couche de recouvrement intérieure (136a) par la pluralité de trous (139), et
dans lequel la première couche de recouvrement (134) et la couche de recouvrement extérieure (136b) s'étendent jusqu'à une partie inférieure des filtres colorés (140).

2. Dispositif de prise d'image selon la revendication 1, dans lequel :
chacune de la couche de recouvrement intérieure (136a) et de la couche de recouvrement extérieure (136b) présente une épaisseur supérieure à une épaisseur de la première couche de recouvrement (134).

3. Dispositif de prise d'image selon la revendication 1, dans lequel :
la couche de recouvrement intérieure (136a) et la couche de recouvrement extérieure (136b) présentent une épaisseur identique.

4. Dispositif de prise d'image selon la revendication 1, dans lequel :
la couche d'air (132) s'étend jusqu'à une position située plus bas qu'une surface inférieure de la première couche de recouvrement (134).

5. Dispositif de prise d'image selon la revendication 1, comprenant en outre :
une couche de support (138) disposée entre la première couche de recouvrement (134) et la couche de recouvrement intérieure (136a).

6. Dispositif de prise d'image selon la revendication 1, dans lequel la structure de grille (130) comporte :
des premières parties s'étendant dans une première direction ; et
des secondes parties s'étendant dans une seconde direction transversale à la première direction et traversant les premières parties,
dans lequel la pluralité de trous (139) est située dans des zones dans lesquelles les premières parties et les secondes parties se croisent.

7. Dispositif de prise d'image selon la revendication 1, dans lequel :
chacune de la première couche de recouvrement (134) et de la seconde couche de recouvrement (136) comporte une couche d'oxyde déposée à ultra-basse température (couche ULTO).

8. Dispositif de prise d'image selon la revendication 1, comprenant en outre :
une couche tampon inférieure (120a) disposée entre un substrat semiconducteur (112) et la structure de grille (130) et disposée entre le substrat semiconducteur (112) et les filtres colorés (140) ; et
une couche tampon supérieure (120b) disposée entre la couche tampon inférieure (120a) et les filtres colorés (140).

9. Dispositif de prise d'image selon la revendication 8, dans lequel :
la première couche de recouvrement (134) et la couche de recouvrement extérieure (136b) s'étendent de façon à fonctionner comme couche tampon supérieure (120b).

10. Dispositif de prise d'image selon la revendication 9, dans lequel :
la couche d'air (132) s'étend jusqu'à un intérieur de la couche tampon inférieure (120a).
